# EUROPEAN PATENT APPLICATION

(11) **EP 1 712 347 A1**
(43) Date of publication of application: **18.10.2006**
(21) Application number: 05709722.2
(22) Date of filing: 04.02.2005
(51) Int. Cl.: B30B 15/34, B29C 59/02

(54) **PRESSING/MOLDING APPARATUS, MOLD, AND PRESSING/MOLDING METHOD**

(30) Priority: 04.02.2004 JP 2004028538
(71) Applicant: SUMITOMO HEAVY INDUSTRIES, LTD., Shinagawa-ku, Tokyo 141-8686 (JP)
(72) Inventor: AKAMATSU, M., c/o SUMITOMO HEAVY INDUSTRIES, LTD., Chiba-shi, Chiba 263-0001 (JP)
(74) Representative: Emde, Eric
(86) International application number: PCT/JP2005/001656
(87) International publication number: WO 2005/075184

(57) **Abstract**

The invention provides a press-molding apparatus, a mold, and a press-molding method, which can shorten a molding cycle and enhance productivity. There are provided a first mold; a second mold disposed to face the first mold and including a substrate (14), a heat insulating member (21) disposed on a side of the substrate (14) facing the first mold, and a machining member disposed on a side of the heat insulating member (21) facing the first mold and having irregularities on a surface facing the first mold; a loading processing section for loading a to-be-machined member on the first mold; a heating processing section for heating the to-be-machined member to a molding temperature higher than a state change point of a material which constitutes the to-be-machined member; and a transfer processing section for pressing the machining member against the to-be-machined member so as to transfer the irregularities to the to-be-machined member. In this case, since the machining member is disposed on the side of the heating insulating member facing the first mold, the machining member can be heated to the molding temperature and cooled to the mold release temperature within a short time.

## Description

### TECHNICAL FIELD

The present invention relates to a press-molding apparatus, a mold, and a press-molding method.

### BACKGROUND ART

Conventionally, in a press-molding apparatus in which a stamper is pressed against a plate-shaped molding preform formed of a resin such as acrylic resin and having a predetermined shape, to thereby transfer thereto a fine pattern previously formed on the stamper, a mold apparatus composed of an upper mold and a lower mold is disposed, and press-compression and mold release are effected by means of advancing and retreating the upper mold. The molding preform is placed on the lower mold, and the upper mold is advanced, while the entire mold apparatus is heated, so as to press the stamper of the upper mold against the molding preform to thereby perform press-compression for transferring the fine pattern to the molding preform, whereby a molded product is produced (see, for example, Patent Document 1).
Patent Document 1: Japanese Patent Application Laid-Open (kokai) No. 2003-1705.

### DISCLOSURE OF THE INVENTION

### PROBLEM TO BE SOLVED BY THE INVENTION

However, in the conventional press-molding apparatus, in order to improve the transfer, the temperature of the molding preform must be increased sufficiently, and thus, the temperature of the entire mold apparatus must be increased sufficiently. Further, a molded product is deformed because of an external force acting thereto when the molded product is removed from the mold apparatus, unless the mold release is performed after the temperature of the molding preform is made lower than a preset mold release temperature (for example, glass-transition point Tg when the molding preform is formed of resin) after completion of the press-compression. Therefore, the mold release is performed after the temperature of the molding preform has decreased to the mold release temperature.

Therefore, the molding cycle is prolonged, and productivity is lowered.

An object of the present invention is to solve the above-mentioned problems in the conventional press-molding apparatus and to provide a press-molding apparatus, a mold, and a press-molding method, which can shorten a molding cycle and enhance productivity.

### MEANS FOR SOLVING THE PROBLEM

To achieve the above object, a press-molding apparatus of the present invention comprises a first mold; a second mold disposed to face the first mold such that the second mold can advance and retreat, the second mold including a substrate, a heat insulating member disposed on a side of the substrate which side faces the first mold, and a machining member disposed on a side of the heat insulating member which side faces the first mold and having irregularities on a surface facing the first mold; a loading processing section for loading a to-be-machined member on the first mold; a heating processing section for heating the to-be-machined member to a molding temperature higher than a state change point of a material which constitutes the to-be-machined member; and a transfer processing section for pressing the machining member against the to-be-machined member so as to transfer the irregularities to the to-be-machined member.

In another press-molding apparatus of the present invention, the heating processing section heats the to-be-machined member having been heated to a preheating temperature lower than the state change point.

In still another press-molding apparatus of the present invention, a heating section for heating the machining member is disposed between the heat insulating member and the machining member.

In still another press-molding apparatus of the present invention, a heating section for heating the machining member is disposed between the first and second molds such that the heating section faces the machining member.

In still another press-molding apparatus of the present invention, a heating section for heating the machining member is incorporated into the machining member.

A mold of the present invention is disposed such that it can advance and retreat in relation to another mold onto which a to-be-machined member is loaded.

The mold comprises a substrate; a heat insulating member disposed on a side of the substrate which side faces the second-mentioned mold; and a machining member disposed on a side of the heat insulating member which side faces the second-mentioned mold and having, on a surface facing the second-mentioned mold, irregularities to be transferred to the to-be-machined member.

In still another mold of the present invention, a heating section for heating the machining member is disposed between the heat insulating member and the machining member.

In still another mold of the present invention, a heating section for heating the machining member is incorporated into the machining member.

A press-molding method of the present invention comprises loading a to-be-machined member onto a first mold; heating a machining member to a molding temperature higher than a state change point of a material which constitutes the to-be-machined member, the machining member being disposed to face the first mold such that the machining member can advance and retreat, disposed on a side of a heat insulating member which side faces the first mold, and having irregularities on a surface facing the first mold; and pressing the machining member against the to-be-machined member so as to transfer the irregularities to the to-be-machined member.

In another press-molding method of the present invention, the to-be-machined member is heated to a preheating temperature lower than the state change point.

### EFFECTS OF THE INVENTION

According to the present invention, a press-molding apparatus comprises a first mold; a second mold disposed to face the first mold such that the second mold can advance and retreat, the second mold including a substrate, a heat insulating member disposed on a side of the substrate which side faces the first mold, and a machining member disposed on a side of the heat insulating member which side faces the first mold and having irregularities on a surface facing the first mold; a loading processing section for loading a to-be-machined member on the first mold; a heating processing section for heating the to-be-machined member to a molding temperature higher than a state change point of a material which constitutes the to-be-machined member; and a transfer processing section for pressing the machining member against the to-be-machined member.

In this case, since the machining member is disposed on the side of the heating insulating member which side faces the first mold, with very low energy consumption and within a short time, the machining member can be heated to the molding temperature and cooled to the mold release temperature. As a result, a molding cycle can be shortened, and productivity can be enhanced.

### BRIEF DESCRIPTION OF THE DRAWINGS

FIG. 1 is a conceptual view of a press-molding apparatus according to a first embodiment of the present invention.
FIG. 2 is a block diagram showing a controller of the press-molding apparatus according to the first embodiment of the present invention.
FIG. 3 is a first view showing a loading step of a press-molding method according to the first embodiment of the present invention.
FIG. 4 is a second view showing the loading step of the press-molding method according to the first embodiment of the present invention.
FIG. 5 is a view showing a press-compression step of the press-molding method according to the first embodiment of the present invention.
FIG. 6 is a view showing a removal step of the press-molding method according to the first embodiment of the present invention.
FIG. 7 is a view showing a loading step of a press-molding method according to a second embodiment of the present invention.
FIG. 8 is a first view showing a loading step of a press-molding method according to a third embodiment of the present invention.
FIG. 9 is a second view showing the loading step of the press-molding method according to the third embodiment of the present invention.
FIG. 10 is a view showing a press-compression step of the press-molding method according to the third embodiment of the present invention.
FIG. 11 is a view showing a removal step of the press-molding method according to the third embodiment of the present invention.

### DESCRIPTION OF SYMBOLS

- 11: lower mold
- 12: upper mold
- 14: substrate
- 21: heat insulating member
- 22: heater
- 23: stamper
- 25: fine pattern
- 34, 85: halogen lamp
- 44: molding preform
- 71: control section
- 81: inductor

### BEST MODE FOR CARRYING OUT THE INVENTION

The embodiments of the present invention will next be described in detail with reference to the drawings.

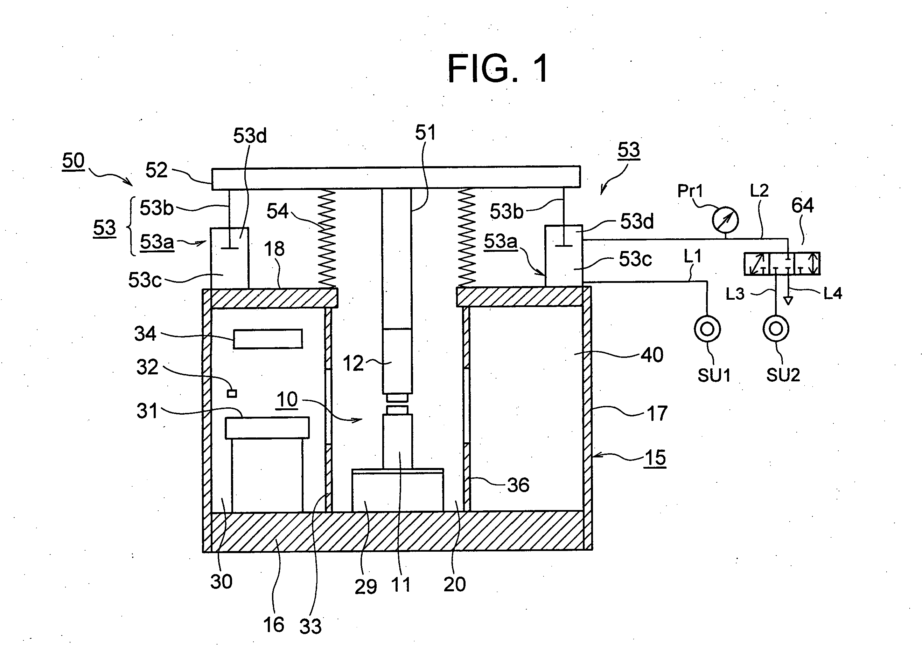

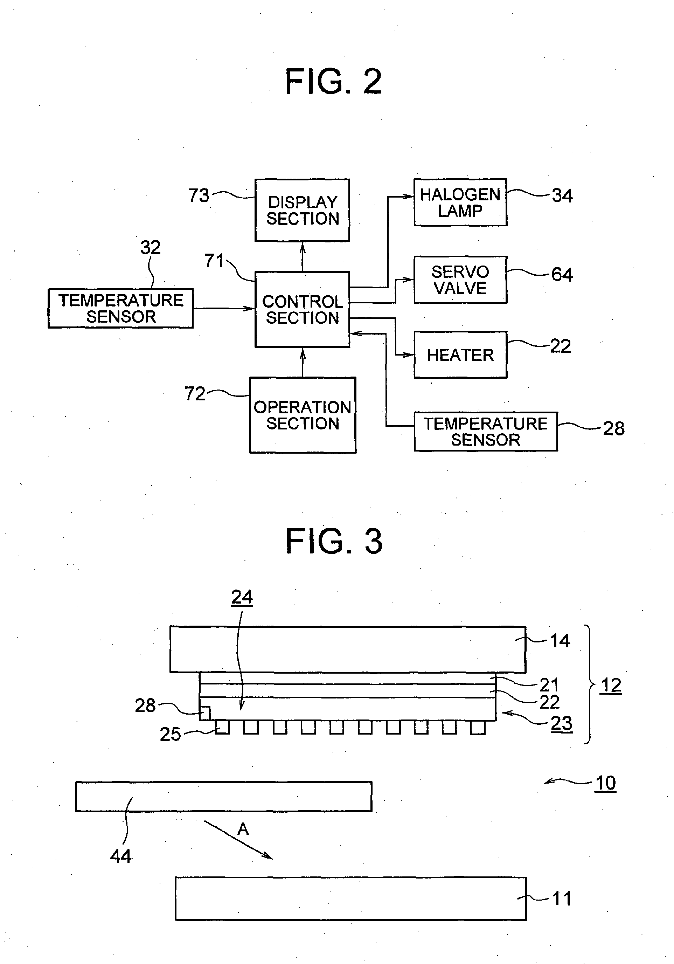

FIG. 1 is a conceptual view of a press-molding apparatus according to a first embodiment of the present invention; and FIG. 2 is a block diagram showing a controller of the press-molding apparatus according to the first embodiment of the present invention.

In FIGS. 1 and 2, reference numeral 15 denotes a housing of the press-molding apparatus, which includes a bottom wall 16, a side wall 17, and a top wall 18. Reference numeral 20 denotes a press-molding section for producing molded products, and a mold apparatus 10 is disposed within the press-molding section 20. The mold apparatus 10 includes a lower mold (first mold) 11 disposed on a mold base 29, and an upper mold (second mold) 12 disposed such that the upper mold 12 faces the lower mold 11 and can advance and retreat (move in the vertical direction in FIG. 1). Notably, if necessary, an unillustrated sleeve-shaped trunk mold may be provided so as to surround the lower mold 11 and the upper mold 12 and guide the upper mold 12. Reference numeral 50 denotes a press apparatus disposed above the press-molding section 20 and adapted to advance and retreat the upper mold 12 to thereby perform press-compression and mold release. In the present embodiment, an optical waveguide or the like is molded as a molded product.

Reference numeral 30 denotes a preheating chamber formed adjacent to the press-molding section 20 via a partition wall 33. An unillustrated molding preform (member to be machined) is conveyed to the preheating chamber 30. After having undergone preheating in the preheating chamber 30, the molding preform is supplied to the press-molding section 20. For such preheating, a table (support member) 31 on which the molding preform is placed, a temperature sensor (first temperature detection section) 32 for detecting temperature T1 of the molding perform, a halogen lamp (heating section) 34 for preheating the molding perform, etc. are disposed within the preheating chamber 30. The molding preform is formed of a resin such as acrylic resin (molding material) and has a predetermined shape. The molding preform may be formed of glass.

The temperature T1 detected by means of the temperature sensor 32 is fed to a control section 71. Unillustrated preheating processing means (first temperature control processing means; preheating processing section) of the control section 71 performs preheating processing (first temperature control processing) so as to turn the halogen lamp 34 on and off to thereby control the temperature T1 to an optimal preheating temperature Tf to be reached before the molding process proceeds to a press-compression step. Through operation of an operation section 72, the preheating temperature Tf is set to a first set temperature slightly lower than a glass-transition point Tg. The glass-transition point Tg is a state change point determined depending on the material of the molding preform.

In the present embodiment, the molding preform is heated by means of the halogen lamp 34. However, the molding preform may be placed on a hot plate so as to be heated by means of the hot plate.

Reference numeral 40 denotes a delivery chamber formed adjacent to the press-molding section 20 via a partition wall 36. A molded product produced in the press-molding section 20 is moved to the delivery chamber 40, and then conveyed to the outside.

The press apparatus 50 includes a press rod (press member) 51 disposed such a manner that the lower end of the press rod 51 faces the upper mold 12 and the press rod 51 can advance and retreat; a press plate 52 attached to the upper end of the press rod 51; a plurality of pneumatic press cylinders (drive sections for pressing) 53 disposed at predetermined locations under the press plate 52; etc.

A bellows (surrounding member) 54 is disposed between the top wall 18 and the press plate 52 to surround the press rod 51. If necessary, the interior of the housing 15 may be sealed, and evacuated. Alternatively, an inert gas atmosphere may be formed in the housing 15.

Notably, in the present embodiment, the press cylinders 53 are used as drive sections for pressing. However, in place of the press cylinders 53, electric motors may be used. In this case, a ball screw or the like serving as a motion direction conversion section is connected to the output shaft of each motor, and rotation of the output shaft is converted to rectilinear motion by means of the ball screw or the like, so that the rectilinear motion is transmitted to the press rod 51.

Each of the press cylinders 53 includes a cylinder portion 53a fixed to the top wall 18, and a rod portion 53b fixed to the press plate 52, and is driven by means of compressed air (drive medium). For such pneumatic drive, a compressed-air source (medium supply source) SU1 is connected to a head-side air chamber (first chamber) 53c of each cylinder portion 53a via a flow passage (medium passage) L1, and a servo valve (valve unit) 64 is connected to a rod-side air chamber (second chamber) 53d of each cylinder portion 53a via a flow passage L2. The servo valve 64, which is switched by means of the control section 71, is connected to a compressed-air source SU2 via a flow passage L3, and communicates with the atmosphere via a flow passage L4. Notably, a pressure sensor Pr1 for detecting pressure of the compressed air is disposed in the flow passage L2. In the present embodiment, compressed air is used as the drive medium; however, oil may be used. Through drive of the press cylinders 53, the press plate 52 and thus the press rod 51 can be advanced and retreated.

Notably, a heater (heating section) 22, a temperature sensor (second temperature detection section) 28, etc., are connected to the control section 71. The heater 22 heats a molding preform when the molding preform undergoes press-compression. The temperature sensor 28 detects temperature T2 of an unillustrated stamper (machining member; core). The temperature T2 detected by means of the temperature sensor 28 is fed to the control section 71. Unillustrated heating processing means (second temperature control processing means; heating processing section) of the control section 71 performs heating processing (second temperature control processing) so as to turn the heater 22 on and off to thereby control the temperature T2 to an optimal molding temperature Tp to be reached after the molding process has proceeded to the press-compression step. Through operation of the operation section 72, the molding temperature Tp is set to a second set temperature higher than the glass-transition point Tg. Notably, in the present embodiment, as will be described later, a fine pattern is transferred to the molding perform, and therefore, the molding temperature Tp is set such that the fine pattern can be transferred sufficiently.

The temperature sensor 28 is attached to the stamper by means of adhesion or the like. However, the temperature sensor 28 may be of a non-contact type, which can be separated from the stamper. Notably, a display section 73 is connected to the control section 71.

Next, a press-molding method will be described.

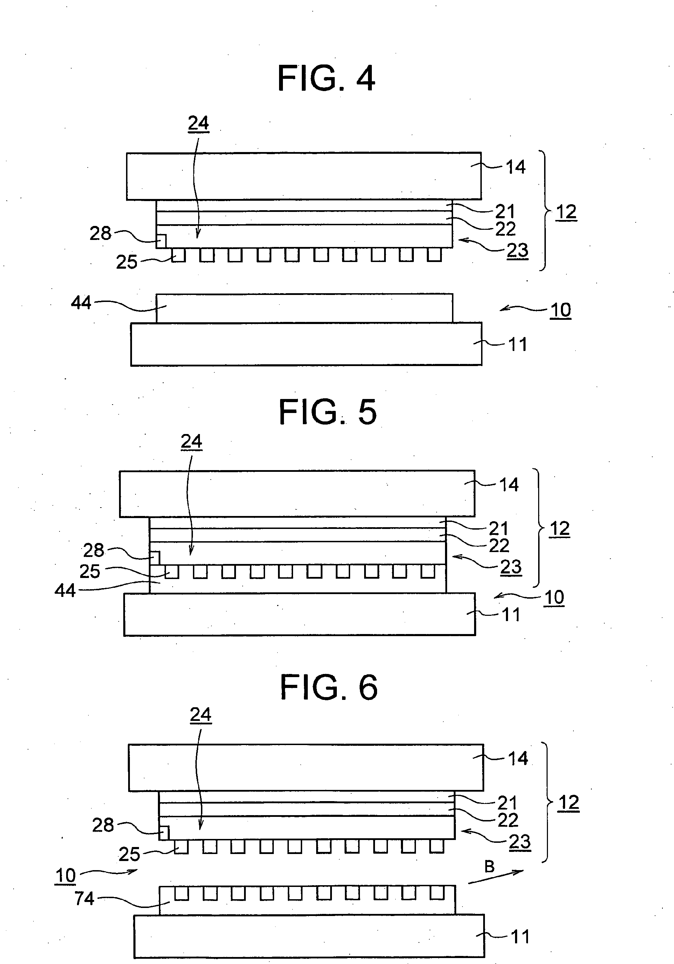

FIG. 3 is a first view showing a loading step of a press-molding method according to the first embodiment of the present invention; FIG. 4 is a second view showing the loading step of the press-molding method according to the first embodiment of the present invention; FIG. 5 is a view showing a press-compression step of the press-molding method according to the first embodiment of the present invention; and FIG. 6 is a view showing a removal step of the press-molding method according to the first embodiment of the present invention.

In these drawings, reference numeral 10 denotes the mold apparatus, 11 denotes the lower mold, and 12 denotes the upper mold. The upper mold 12 includes a substrate 14; a heat insulating member 21 disposed on a side of the substrate 14 facing the lower mold 11, that is, on the substrate 14; the heater 22 disposed on a side of the heat insulating member 21 facing the lower mold 11, that is, on the heat insulating member 21; a thin-plate-shaped stamper 23 detachably attached on a side of the heater 22 facing the lower mold 11, that is, on the heater 22; etc. The stamper 23 has a fine pattern 25; that is, fine pits arranged in a predetermined pattern are formed on a front surface of a body portion 24 thereof; that is, a surface facing the lower mold 11. The stamper 23 is attached to the upper mold 12 by means of unillustrated attachment members in such a manner that the fine pattern 25 faces the lower mold 11. The temperature sensor 28 is disposed at a predetermined location on the body portion 24. Notably, if necessary, a temperature control medium passage may be formed in the substrate 14 so as to control the temperature of the substrate 14. In this case, a medium for temperature control may be caused to flow through the temperature control medium passage.

First, in the loading step, the preheating processing means of the control section 71 (FIG. 2) performs the preheating processing so as to supply electricity to the halogen lamp 34 to thereby preheat the molding preform 44 such that the temperature T1 of the molding preform 44 reaches a preheat temperature Tf slightly lower than the glass-transition point Tg.

Subsequently, unillustrated loading processing means (loading processing section) of the control section 71 performs loading processing. That is, the loading processing means operates an unillustrated handling apparatus to hold the molding preform 44 within the preheating chamber 30 (FIG. 1), transfer it to the press-molding section 20, and then place it on the lower mold 11, as shown by arrow A in FIG. 3. In this manner, the loading processing means loads the molding preform 44 onto the mold apparatus 10 as shown in FIG. 4.

Next, in the press-compression step, the heating processing means of the control section 71 performs heating processing. That is, in order to enable transfer of the fine pattern 25, the heating processing means supplies electricity to the heater 22 so as to heat the stamper 23 such that the temperature T2 of the stamper 23 reaches a molding temperature Tp higher than the glass-transition point Tg. Subsequently, unillustrated transfer processing means (transfer processing section) of the control section 71 operates the press apparatus 50 at a predetermined timing so as to drive the press cylinders 53 to thereby advance (move downward in FIG. 1) the press plate 52 and the press rod 51, whereby the stamper 23 is pressed against the molding preform 44 as shown in FIG. 5, and thus, press-compression is performed. At this time, in order to enable transfer of the fine pattern 25, only a surface portion of the molding preform 44 in contact with the stamper 23 is heated by means of transferred heat, whereby, as in the case of the stamper 23, the temperature of the surface portion of the molding perform 44 is increased to the molding temperature Tp higher than the glass-transition point Tg so as to enable sufficient transfer of the fine pattern 25 to the molding preform 44. Accordingly, the fine pattern 25 can be transferred to the molding preform 44 as a result of the press-compression.

Incidentally, when the temperature T2 becomes equal to or higher than the glass-transition point Tg, the resin which constitutes the molding preform 44 is softened, its molecular motion becomes active, and the resin enters a glass state. In this case, since the surface portion of the molding preform 44 is heated to the molding temperature Tp higher than the glass-transition point Tg, the fine pattern 25 can be well transferred to the molding preform 44, whereby the transfer performance can be improved.

Further, before commencing the press-compression step, the temperature T1 of the molding preform is previously increased to the preheat temperature Tf slightly lower than the glass-transition point Tg within the preheating chamber 30; and upon commencing the press-compression step, heating of the molding preform from the preheat temperature Tf is started by means of the heater 22. Therefore, the time required to increase the temperature T2 to the molding temperature Tp can be shortened. Accordingly, the molding cycle can be shortened, and productivity can be enhanced.

Subsequently, in the removal step, unillustrated removal processing means (removal processing section) of the control section 71 performs removal processing. That is, the removal processing means reads the temperature T2 detected by means of the temperature sensor 28, and waits until the temperature T2 becomes a mold release temperature Ts optimal for mold release. In this case, the removal processing means can wait until the molding preform 44 is cooled by means of self-cooling. Alternatively, a cooling medium passage is formed in the lower mold 11, the heater 22, the stamper 23, etc., and a cooling medium such as water is caused to flow through the cooling medium passage so as to cool the molding preform 44.

Notably, through operation of the operation section 72, the mold release temperature Ts is set to a third set temperature which is lower than the glass-transition point Tg and which enables reliable mold release.

When the temperature T2 becomes the mold release temperature Ts, the removal processing means operates the press apparatus 50 so as to drive the press cylinders 53 to thereby retreat (move upward in FIG. 1) the press plate 52 and the press rod 51, whereby the upper mod 12 is separated from the molding preform 44. As a result, a molded product 74 can be obtained. Subsequently, the removal processing means operates the handling apparatus to hold the molded product 74 within the press-molding section 20, remove it as shown by arrow B in FIG. 6, and transfer it to the delivery chamber 40. In this manner, the removal processing means can transfer the molding preform 44 from the press-molding section 20.

In this case, since the temperature T2 is made lower than the glass-transition point Tg, even when an external force acts on the molded product 74 when the molded product 74 is removed, deformation of the molded product 74 is prevented.

Incidentally, in the present embodiment, the heater 22 is disposed on the heat insulating member 21, and the stamper 23 is attached to the heater 22, so that the heater 22 is disposed between the heat insulating member 21 and the stamper 23. Therefore, heat generated upon supply of electricity to the heater 22 is not transferred to the substrate 14 but only to the stamper 23. Further, when the stamper 23 is cooled, heat of the substrate 14 is not transferred to the stamper 23. That is, a heated portion to be heated by means of the heater 22 and a cooled portion to be cooled are limited to only the stamper 23, and the heat capacity of the stamper 23 is considerably small. Therefore, with very low energy consumption and within a short time, the stamper 23 (temperature T2) can be heated to the molding temperature Tp and cooled to the mold release temperature Ts, whereby the temperature of the surface portion of the molding preform 44 can be reduced to the mold release temperature Ts. As a result, the molding cycle can be further shortened, and productivity can be enhanced.

Further, although the temperature T1 of the molding preform 44 before the stamper 23 is pressed against the molding preform 44 is lower than the temperature T2 of the stamper 23, the heat of the stamper 23 rapidly moves to the molding preform 44 when the stamper 23 is pressed against the molding preform 44. In this case, since the heat capacity of the stamper 23 is sufficiently small, the temperature T2 of the stamper 23 can be quickly lowered as the heat of the stamper 23 moves to the molding preform 44. Accordingly, the temperature T2 can be decreased to the mold release temperature Ts within a short time, whereby the molding cycle can be further shortened, and productivity can be enhanced.

Notably, when the molded product is an optical waveguide, the fine pattern 25 has a depth of several tens of microns to the submicron order. Therefore, only the surface portion of the molding preform 44 must be heated to the molding temperature Tp. Therefore, even when the thickness of the stamper 23 is sufficiently reduced so as to reduce the heat capacity, transfer of the fine pattern 25 can be performed well.

In the present embodiment, the heater 22 is formed separately from the stamper 23. However, the heater 22 may be incorporated in the stamper 23.

Next, a second embodiment of the present invention will be described. Notably, components having the same structures as those in the first embodiment are denoted by the same reference numerals, and their descriptions are omitted. As to the effects of the present invention achieved by structural features corresponding to those in the first embodiment, the description of the effects of the first embodiment applies.

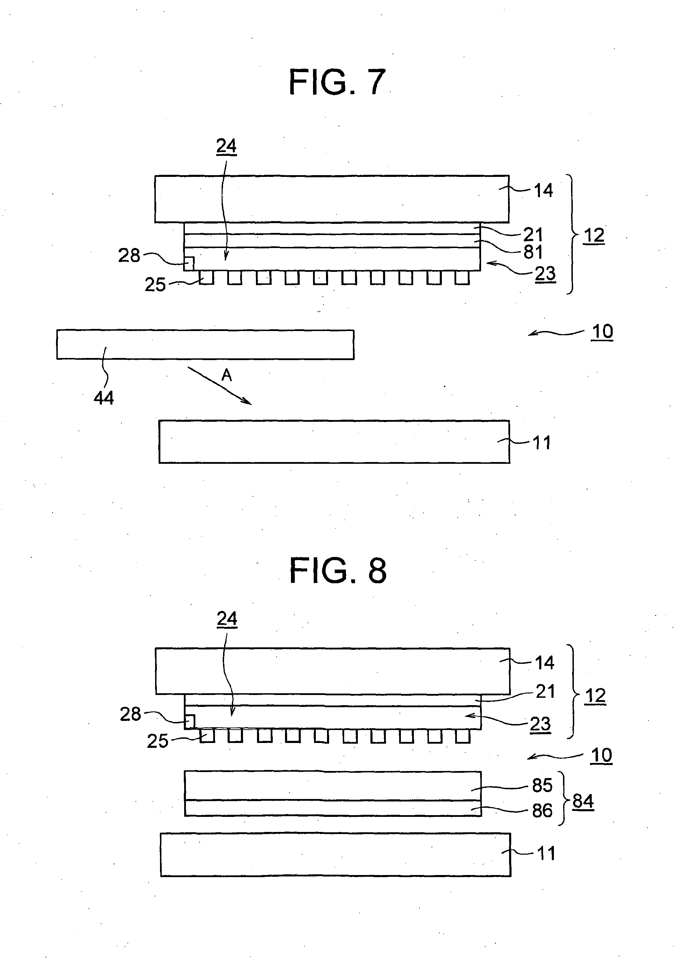

FIG. 7 is a view showing a loading step of a press-molding method according to the second embodiment of the present invention.

In this case, an inductor 81 for induction heating is disposed on the heat insulating member 21 as a heating section, and the stamper 23, which serves as a machining member and a core, is attached to the inductor 81. Heat generated as a result of induction heating performed through supply of electricity to the inductor 81 is not transferred to the substrate 14 but only to the stamper 23. In this case as well, the heated portion to be heated by means of the heater 22 is limited to only the stamper 23, so that the heat capacity of the heated portion can be reduced.

Next, a third embodiment of the present invention will be described. Notably, components having the same structures as those in the first embodiment are denoted by the same reference numerals, and their descriptions are omitted. As to the effects of the present invention achieved by structural features same as those in the first embodiment, the description of the effects of the first embodiment applies.

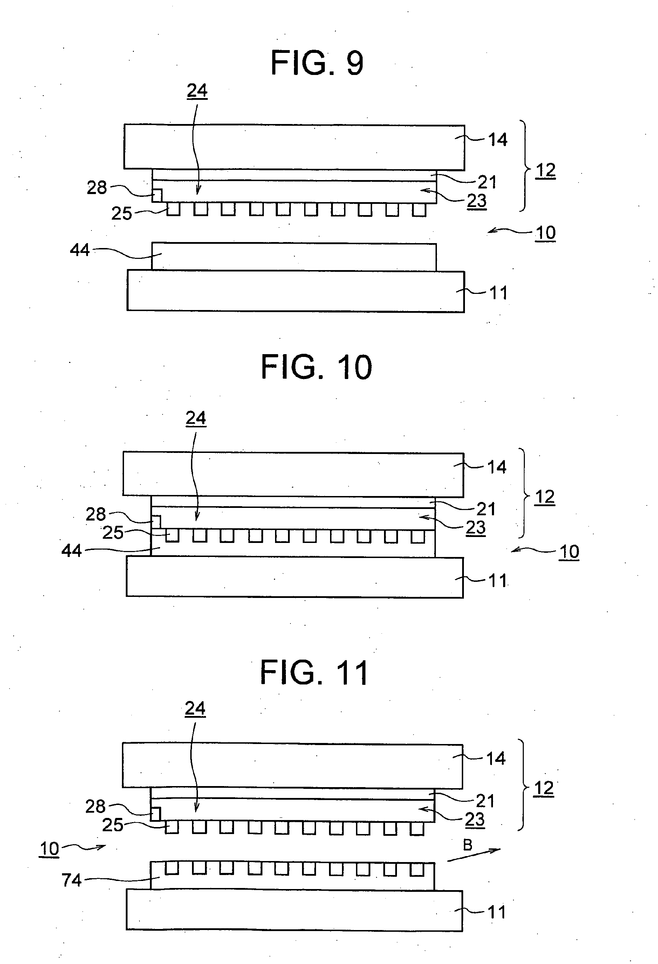

FIG. 8 is a first view showing a loading step of a press-molding method according to the third embodiment of the present invention; FIG. 9 is a second view showing the loading step of the press-molding method according to the third embodiment of the present invention; FIG. 10 is a view showing a press-compression step of the press-molding method according to the third embodiment of the present invention; and FIG. 11 is a view showing a removal step of the press-molding method according to the third embodiment of the present invention.

First, in the loading step, the preheating processing means of the control section 71 (FIG. 2) performs the preheating processing so as to supply electricity to the halogen lamp 34 serving as a heating section to thereby preheat the molding preform (material to be machined) 44 such that the temperature T1 of the molding preform 44 reaches a preheat temperature Tf slightly lower than the glass-transition point Tg. At this time, as shown in FIG. 8, a heating apparatus 84 is placed between the lower mold 11 and the upper mold 12. The heating apparatus 84 includes a flat-shaped halogen lamp (heating section) 85 disposed to face the stamper 23, which serves as a machining member and a core, and a reflection plate 86 disposed on the back of the halogen lamp 85. Subsequently, the heating processing means of the control section 71 performs heating processing. That is, the heating processing means supplies electricity to the halogen lamp 85, so that the stamper 23 is irradiated with light and heated, and the temperature of the stamper 23 reaches the molding temperature Tp higher than the glass-transition point Tg.

Subsequently, the loading processing means of the control section 71 performs loading processing. That is, the loading processing means removes the heating apparatus 84 from the space between the lower mold 11 and the upper mold 12, and operates the handling apparatus to hold the molding preform 44 within the preheating chamber 30 (FIG. 1), transfer it to the press-molding section 20, and then place it on the lower mold 11, as shown in FIG. 9. In this manner, the loading processing means loads the molding preform 44 onto the mold apparatus 10.

Next, in the press-compression step, the transfer processing means of the control section 71 performs the transfer processing. That is, the transfer processing means operates the press apparatus 50 so as to drive the press cylinders 53 to thereby advance the press plate 52 and the press rod 51, whereby the stamper 23 is pressed against the molding preform 44 as shown in FIG. 10, and the heat is transferred to the molding preform 44. As a result, the surface portion of the molding preform 44 is heated to the molding temperature Tp higher than the glass-transition point Tg, and press-compression is performed so as to transfer the fine pattern 25.

Subsequently, in the removal step, the removal processing means of the control section 71 performs removal processing means. That is, the removal processing means reads the temperature T2 detected by means of the temperature sensor 28, and waits until the temperature T2 becomes the mold release temperature Ts optimal for mold release.

When the temperature T2 becomes the mold release temperature Ts, the removal processing means operates the press apparatus 50 so as to drive the press cylinders 53 to thereby retreat the press plate 52 and the press rod 51, whereby the upper mod 12 is separated from the molding preform 44. As a result, a molded product 74 can be obtained. Subsequently, the removal processing means operates the handling apparatus to hold the molded product 74 within the press-molding section 20, remove it as shown by arrow B in FIG. 11, and transfer it to the delivery chamber 40. In this manner, the removal processing means can transfer the molding preform 44 from the press-molding section 20.

In the present embodiment, an optical waveguide is produced as a molded product. However, a disk substrate may be produced as a molded product.

The present invention is not limited to the above-described embodiments. Numerous modifications and variations of the present invention are possible in light of the spirit of the present invention, and they are not excluded from the scope of the present invention.

### INDUSTRIAL APPLICABILITY

The present invention can be applied to a press-molding apparatus in which molded products are produced by use of a stamper.

## Claims

1. A press-molding apparatus **characterized by** comprising:
(a) a first mold;
(b) a second mold disposed to face the first mold such that the second mold can advance and retreat, the second mold including a substrate, a heat insulating member disposed on a side of the substrate which side faces the first mold, and a machining member disposed on a side of the heat insulating member which side faces the first mold and having irregularities on a surface facing the first mold;
(c) a loading processing section for loading a to-be-machined member on the first mold;
(d) a heating processing section for heating the to-be-machined member to a molding temperature higher than a state change point of a material which constitutes the to-be-machined member; and
(e) a transfer processing section for pressing the machining member against the to-be-machined member so as to transfer the irregularities to the to-be-machined member.

2. A press-molding apparatus according to claim 1, wherein the heating processing section heats the to-be-machined member having been heated to a preheating temperature lower than the state change point.

3. A press-molding apparatus according to claim 1, wherein a heating section for heating the machining member is disposed between the heat insulating member and the machining member.

4. A press-molding apparatus according to claim 1, wherein a heating section for heating the machining member is disposed between the first and second molds such that the heating section faces the machining member.

5. A press-molding apparatus according to claim 1, wherein a heating section for heating the machining member is incorporated into the machining member.

6. A mold to be disposed such that it can advance and retreat in relation to another mold onto which a to-be-machined member is loaded, the mold being **characterized by** comprising:
(a) a substrate;
(b) a heat insulating member disposed on a side of the substrate which side faces the second-mentioned mold; and
(c) a machining member disposed on a side of the heat insulating member which side faces the second-mentioned mold and having, on a surface facing the second-mentioned mold, irregularities to be transferred to the to-be-machined member.

7. A mold according to claim 6, wherein a heating section for heating the machining member is disposed between the heat insulating member and the machining member.

8. A mold according to claim 6, wherein a heating section for heating the machining member is incorporated into the machining member.

9. A press-molding method **characterized by** comprising:
(a) loading a to-be-machined member onto a first mold;
(b) heating a machining member to a molding temperature higher than a state change point of a material which constitutes the to-be-machined member, the machining member being disposed to face the first mold such that the machining member can advance and retreat, disposed on a side of a heat insulating member which side faces the first mold, and having irregularities on a surface facing the first mold; and
(c) pressing the machining member against the to-be-machined member so as to transfer the irregularities to the to-be-machined member.

10. A press-molding method according to claim 9, wherein the to-be-machined member is heated to a preheating temperature lower than the state change point.
